(19) Europäisches Patentamt
European Patent Office
Office européen des brevets

(11) Publication number: 0 557 943 A2

# (12) EUROPEAN PATENT APPLICATION

(21) Application number: 93102805.4

(22) Date of filing: 24.02.93

(51) Int. Cl.⁵: C08G 79/02, C08F 283/00, C08F 299/02

(30) Priority: 25.02.92 JP 37693/92

(43) Date of publication of application: 01.09.93 Bulletin 93/35

(84) Designated Contracting States: BE CH DE FR GB IT LI NL SE

(71) Applicant: IDEMITSU PETROCHEMICAL CO. LTD.
1-1, Marunouchi 3-chome Chiyoda-ku
Tokyo 100(JP)

(72) Inventor: Ando, Hiroyuki, c/o Idemitsu Petrochemical Co.,Ltd
1660, Kamiizumi
Sodegaura-shi, Chiba-ken(JP)

(74) Representative: Türk, Gille, Hrabal, Leifert
Brucknerstrasse 20
D-40593 Düsseldorf (DE)

## (54) Curable resin composition.

(57) Disclosed herein is a curable resin composition comprising (A) a curable phosphazene compound, (B) a multifunctional (meth)acrylate-based compound such as dipentaerythritol hexaacrylate and (C) a crosslinkable compound having a cure shrinkage of 6% or less such as (meth)acrylate modified polymer which is a product modified by epoxy. This resin composition provides a cured resin film having a high rate of cure, tractable to coat in a great thickness and further excellent in surface hardness, transparency and weathering resistance.

EP 0 557 943 A2

## BACKGROUND OF THE INVENTION

### 1. Field of the Invention

The present invention relates to a curable resin composition. More particularly, it relates to a curable resin composition wherein a curable phosphazene compound is used, capable of providing a cured resin film having a high rate of cure, tractable to coat in a great thickness and further excellent in surface hardness, transparency and weathering resistance.

### 2. Description of the Related Arts

Curable resins or curable resin compositions can easily be cured in response to the irradiation of a heat ray or an activation energy ray, finding the wide application in various coating materials, protective film forming materials, filler-curative agents and the like.

Of curable resins, a curable phosphazene compound has especially been found to be useful because it is excellent in the mechanical properties such as surface hardness and further in heat resistance and the like.

Though it has these excellent properties, the curable phosphazene compound has a problem in that it has a comparatively low rate of cure. Thus, the technique aimed at solving this problem has been disclosed in, for example the Japanese Patent Application Laid Open No. 129210/1990. According to this patent, a multifunctional acrylate-based compound is mixed with the curable phosphazene compound so that the resultant mixture may be highly productive with a high rate of cure.

However, the curable resin composition comprising the curable phosphazene compound, the multifunctional acrylate-based compound and the like has a shortcoming that a film made from it, if coated in a great thickness, for example of more than 20 $\mu$m, is liable to crack or peel.

## SUMMARY OF THE INVENTION

Under these circumstances, the present inventor has made intensive studies with an intent to find a solution in these difficulties of related arts and develop a curable resin composition capable of providing a cured resin surface having a high rate of cure, tractable to coat in a great thickness, and further excellent in surface hardness, transparency, weathering resistance and the like and free from cracks and peels. As the result, it has been found that the curable resin composition having the desired properties can be obtained by adding a compound having a low cure shrinkage. The present invention has been completed on the basis of this finding.

Accordingly, the present invention provides a curable resin composition comprising (A) a curable phosphazene compound, (B) a multifunctional (meth)acrylate-based compound and (C) a crosslinkable compound having a cure shrinkage of 6% or less.

## DESCRIPTION OF THE PREFERRED EMBODIMENTS

The curable phosphazene compound to be used as the component (A) of the present invention includes, for example a phosphazene compound having a repeating unit represented by the general formula (I):

$$\left\{ NP(A)_a(B)_b \right\} \qquad (I)$$

wherein A represents a polymerizable and curable group, B represents a polymerizable and non-curing group and a and b represent real numbers mutually satisfying $0<a$, $0\leqq b$ and $a+b=2$. It can take various forms depending upon the kind of substituents.

In the formula, A represents a polymerizable and curable group. The term "polymerizable and curable group" means a functional group which is cured in response to the irradiation of an ultraviolet ray, a visible ray or an electron beam, with the use of a chemical curative agent or by heating, ordinarily having a reactive double bond. There are various groups having the reactive double bond, and their examples include a functional group containing an acryloyl group, a methacryloyl group, an allyl group or a vinyl group.

The functional group containing the acryloyl group or methacryloyl group occurs as an acryloyloxy group, a methacryloyloxy group and further a group represented by the general formula (II):

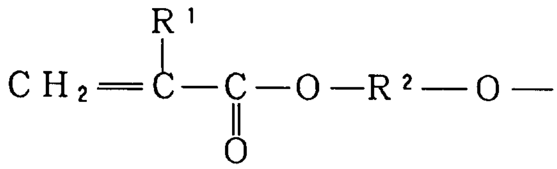 · · · (II)

wherein $R^1$ represents a hydrogen atom or a methyl group, $R^2$ represents an alkylene group having 1 to 12 (preferably 1 to 5) carbon atoms (including a branched alkylene group).

Specific examples of the group represented by the general formula (II) include 2-hydroxyethyl methacrylate, 2-hydroxypropyl methacrylate, 3-hydroxypropyl methacrylate, 2-hydroxybutyl methacrylate, 3-hydroxybutyl methacrylate, 4-hydroxybutyl methacrylate, 5-hydoxypentyl methacrylate, 6-hydroxy-3-methylhexyl methacrylate, 5-hydroxyhexyl methacrylate, 3-hydroxy-2-t-butylpropyl methacrylate, 3-hydroxy-2,2-dimethylhexyl methacrylate, 3-hydroxy-2-methyl-2-ethylpropyl methacrylate and a residual group obtained by removing hydrogen atoms from a hydroxyl group of the methacrylates such as 12-hydroxydodecyl methacrylate, as well as 2-hydroxyethyl acrylate, 2-hydroxypropyl acrylate, 3-hydroxypropyl acrylate, 2-hydroxybutyl acrylate, 3-hydroxybutyl acrylate, 4-hydroxybutyl acrylate, 5-hydroxypentyl acrylate, 6-hydroxy-3-methylhexyl acrylate, 5-hydroxyhexyl acrylate, 3-hydroxy-2-t-butylpropyl acrylate, 3-hydroxy-2,2-dimethylhexyl acrylate, 3-hydroxy-2-methyl-2-ethylpropyl acrylate and a residual group obtained by removing hydrogen atoms from a hyroxyl group of the acrylates such as 12-hydroxydodecyl acrylate. Particularly preferred among them are the 2-hydroxyethyl methacrylate residue and the 2-hydroxyethyl acrylate residue.

Furthermore, beside those represented by above-mentioned general formula (II), examples of the functional group containing the acryloyl group or methacryloyl group also include a functional group represented by the general formula (III):

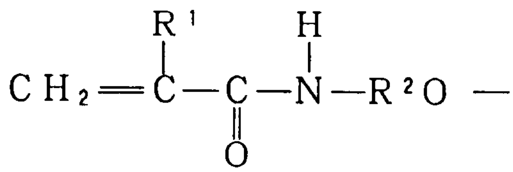 · · · (III)

wherein $R^1$ and $R^2$ have the same meaning as defined above. That is a residual group obtained by removing hydrogen atoms from a hydroxyl group of a hydroxyalkyl-substituted (meth)acrylamide.

Said examples further include a functional group represented by the general formula (IV):

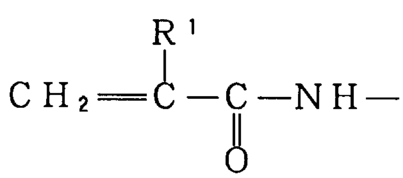 · · · (IV)

wherein $R^1$ has the same meaning as defined above. That is a residual group obtained by removing a hydrogen atom from an amino group of an acrylamide or methacrylamide.

The functional group containing the allyl group is exemplified by not only an allyl group per se but also an allyloxy group ($CH_2=CH\text{-}CH_2O\text{-}$), but its examples are not limited to the above allyloxy group, including a wide variety of functional groups represented by the general formulae (V) to (VII):

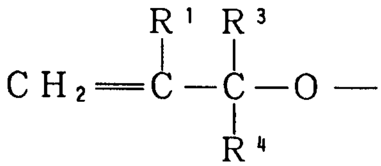 • • • (V)

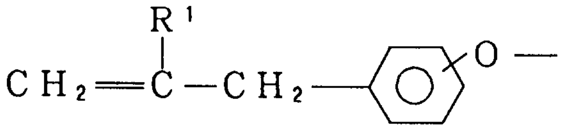 • • • (VI)

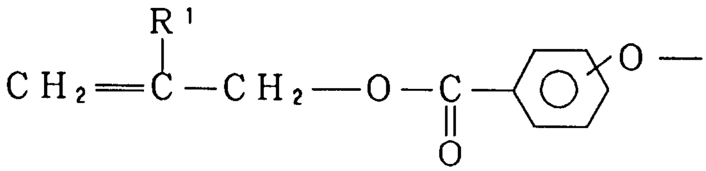 • • • (VII)

wherein $R^1$ has the same meaning as defined above, $R^3$ and $R^4$ each represent a hydrogen atom or an alkyl group having 1 to 4 carbon atoms. These functional groups are a residual group obtained by removing hydrogen atoms from the one and only hydroxyl group of an allyl compound. Specific examples of the functional groups represented by the general formulae (V) to (VII) include a residual group obtained by removing hydrogen atoms from a hyroxyl group of each of the following allyl compounds:

$CH_2=CH-CH_2-OH$, 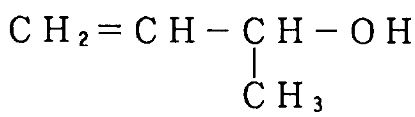 ,

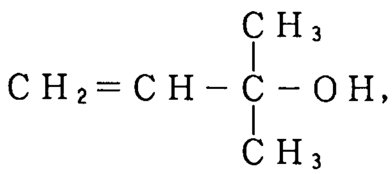 , 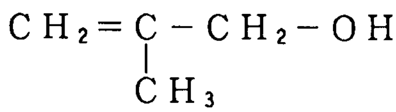 ,

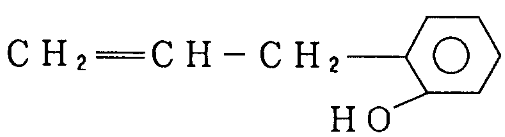 ,

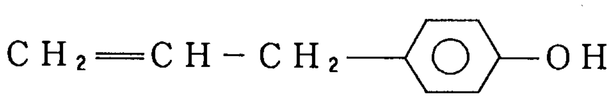 ,

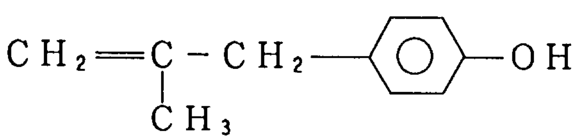 ,

On the the other hand, B of the general formula (I) is groups represented by the general formula (VIII) or (IX): $R^5$ M- (VIII)

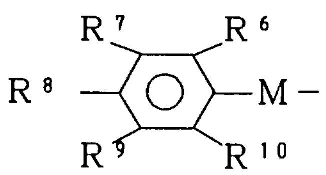

· · · (IX)

wherein M represents an oxygen atom, a sulfur atom or an imino group, $R^5$ represents an alkyl group having 1 to 18 carbon atoms or a halogenatedalkyl group having 1 to 18 carbon atoms and $R^6$ to $R^{10}$ each independently represent a hydrogen atom, a halogen atom, an alkyl group having 1 to 4 carbon atoms or a halogenated alkyl group having 1 to 4 carbon atoms.

Specific examples of the group represented by the general formula (VIII) include a methoxy group, an ethoxy group, a propoxy group, a butoxy group, a pentyloxy group, a hexyloxy group, a heptyloxy group, an octyloxy group, a decyloxy group, a dodecyloxy group, a hexadecyloxy group, an alkoxy group such as octadecyloxy group, a halogen (for example, fluorine, chlorine, bromine and the like)-substituted alkoxy group of the same kind, a methylthio group, an ethylthio group, a propylthio group, a butylthio group, a pentylthio group, a hexylthio group, a decylthio group, a dodecylthio group, a hexadecylthio group, a heptylthio group, an alkylthio group such as octylthio group, a halogen (for example, fluorine, chlorine, bromine and the like)-substituted alkylthio group of the same kind, a methylimino group, an ethylimino group, a propylimino group, a butylimino group, a pentylimino group, a hexylimino group, a heptylimino group, an octylimino group, a decylimino group, a dodecylimino group, a hexadecylimino group, an alkylimino group such as octadecylimino group and a halogen (for example, fluorine, chlorine, bromine and the like)-substituted alkylimino group of the same kind.

Specific examples of the group represented by the general formula (IX) include a phenoxy group, a thiophenyl group, a halogenated phenoxy group (2,4,6-tribromophenoxy group, 4-bromophenoxy group, 2-chlorophenoxy group, 2,4-dichlorophenoxy group and the like) and a halogenated thiophenyl group (4-chlorophenylthio group and the like) or a residual group obtained by removing hydrogen atoms from an amino group of an aniline and a halogenated aniline (2-chloroaniline, 2,4-dichloroaniline, 2,4,6-tribromoaniline and the like).

Furthermore, in above-mentioned general formula (I), a and b are the real numbers mutually satisfying $0<a\leqq2$, $0\leqq b<2$ and $a+b=2$, preferably $0.6\leqq a\leqq2$ and $0\leqq b\leqq1.4$.

Meanwhile, the substituent A acts to cure the phosphazene compound represented by the general formula (I) when it is polymerized (cured), while the substituent B is responsible for the action to control the physical properties and polymerization performance of the so obtained polymer.

However, a phosphazene compound falling under $a=0$ is not curable and should be ruled out from the materials to be used in the present invention. On the other hand, a phosphazene compound falling under $a=2$ and $b=0$ or having a repeating unit represented by the formula:

$$\{ NP(A)_2 \}$$

wherein A has the same meaning as defined above can be used as a raw material for the curable compound of the present invention, enabling the present invention to achieve better curing efficiency.

Preferred as the curable phosphazene compounds to be used in the present invention are those having the repeating unit represented by the general formula (I) and further a polymerization degree of 3 or more, preferably in a range of 3 to 10,000 and more preferably in a range of 3 to 18. Most preferable is a phosphazene compound having the polymerization degree of 3 or 4 or a mixture of these two. Furthermore, the curable phosphazene compound may comprise bonding (polymerizing) the repeating units represented by the general formula (I) one another in the form of a chain. Preferable is a product resulting from bonding (polymerizing) them in a cyclic form, however. Specific examples of such a phosphazene compound are as follows:

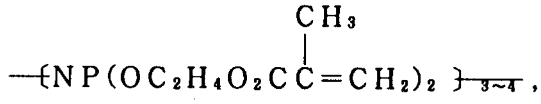

$-\{NP(OCH_2CH=CH_2)_2\}_{3\sim4}$ ,

$-\{NP(OC_2H_4O_2CCH=CH_2)_2\}_{3\sim4}$ ,

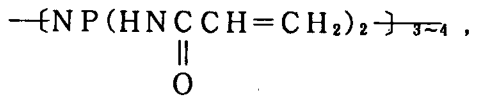

$-\{NP\ \{(OCH_2CH_3)(OC_2H_4O_2CCH=CH_2)\}\}_{3\sim4}$ ,

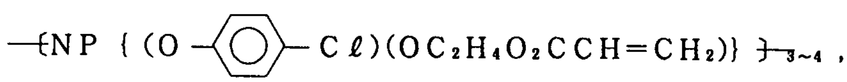

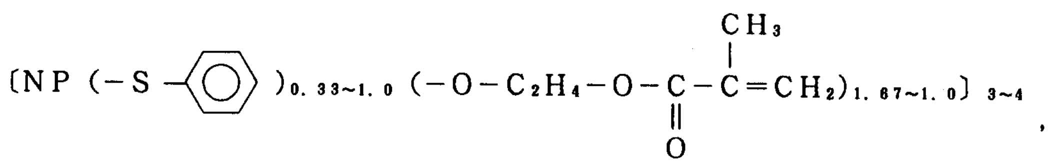

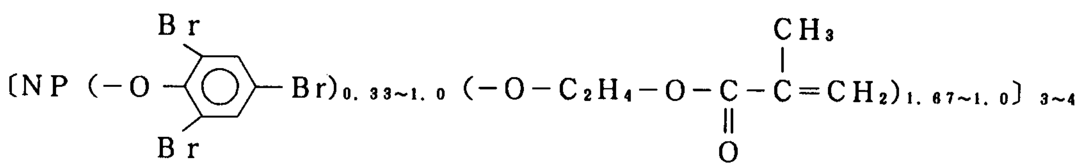

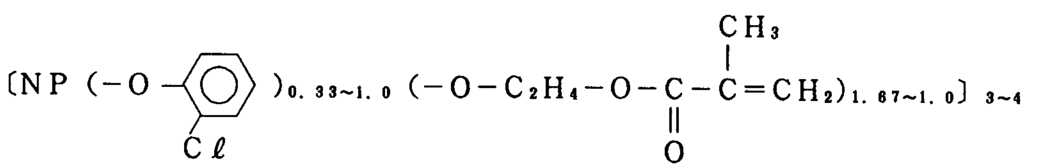

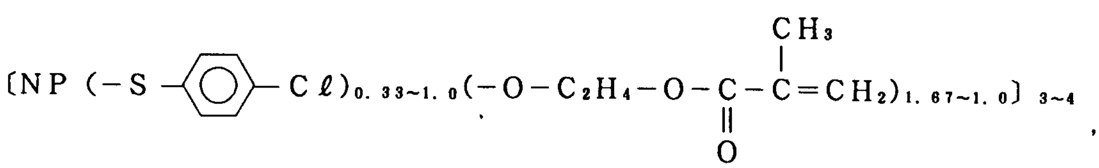

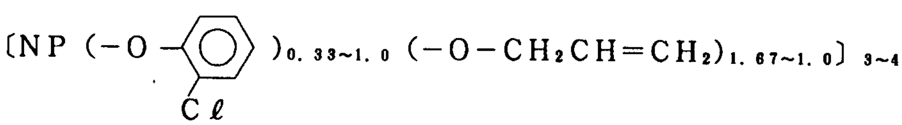

On the other hand, the group represented by the general formula (VIII) to be used as the substituent B is derived from an alkanol, a halogenated alkanol or a derivative thereof represented by:

$R^5$ OH

wherein $R^5$ has the same meaning as defined above, when M is an oxygen atom; it is derived from an alkylmercaptan, a halogenated alkylmercaptan or a derivative thereof represented by:

$R^5$ SH

wherein $R^5$ has the same meaning as defined above, when M is a sulfur atom; and it is derived from an alkylamine, a halogenated alkylamine or a derivative thereof represented by:

$R^5$ $NH_2$

wherein $R^5$ has the same meaning as defined above, when M is an imino group.

Furthermore, the group represented by the general formula (IX) to be used as the substituent B is derived from the phenols represented by the general formula:

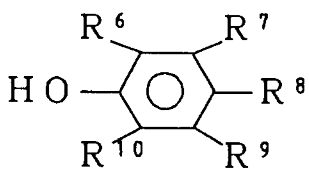

wherein $R^6$ to $R^{10}$ have the same meaning as defined above, when M is an oxygen atom; it is derived from the thiophenols represented by the general formula:

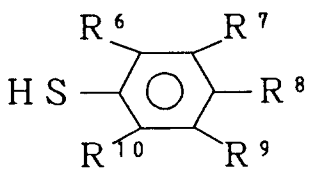

wherein $R^6$ to $R^{10}$ have the same meaning as defined above, when M is a sulfur atom; and it is derived from an aniline or a derivative thereof represented by the general formula:

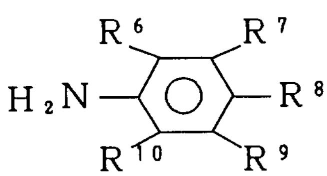

wherein $R^6$ to $R^{10}$ have the same meaning as defined above, when M is an imino group.

The desired phosphazene compound represented by the general formula (I) can be obtained by reacting a compound forming the substituent A and a compound forming the substituent B with a chlorophosphazene [a cyclic compound represented by the formula $(NPCl_2)_n$ or a chain compound represented by the formula $Cl_4P\bullet(NPCl_2)_{n-1}NPCl_3$ wherein n is an integer of 3 or more, preferably 3 to 18] and the like.

Meanwhile, when the alcohols, the mercaptans, the phenols or the thiophenols are intended for use as the substituent B, those compounds may be previously reacted with an alkaline metal such as metallic sodium or metallic potassium to be converted into the alcoholates, the phenolates, the mercaptides or the thiophenolates.

It is preferable that a dehydrohalogenation agent such as tertiary amine should participate in the reaction of the compounds respectively forming the substituents A and B with the chlorophosphazene. Examples of this tertiary amine include trimethylamine, triethylamine, triisopropylamine, tri-n-propylamine, tri-n-butylamine, pyridine and the like, and the most suitable among them is pyridine.

Furthermore, this reaction is carried out ordinarily in an organic solvent. Examples of the organic solvent for use include benzene, toluene, xylene, chloroform, cyclohexane, methylene chloride, tetrahydrofuran, 1,4-dioxane and the like. They can be used singly or in combination.

Furthermore, it is preferable that the curable phosphazene compound is obtained from above-mentioned reaction, relieved of all the chlorine atoms of chlorophosphazene, the raw material, on account of the substitution due to the substituents set forth above. But a part of those chlorine atoms may inoffensively remain unsubstituted.

The above reaction provides a curable phosphazene compound as the chief raw material from which to obtain a phosphazene-based polymer.

Next, the multifunctional (meth)acrylate-based compound (including a multifunctional methacrylate-based compound; hereinafter sometimes referred to as a "multifunctional (meth) acrylate-based compound") to be used as the component (B) is divided into ① a multifunctional (meth)acrylate monomer, ② a multifunctional (meth)acrylate oligomer and ③ a multifunctional urethane (meth)acrylate.

Examples of the multifunctional (meth)acrylate monomer ① include 1,3-butanediol di(meth)acrylate, 1,4-butanediol di(meth)acrylate, 1,6-hexanediol di(meth)acrylate, ethyleneglycol di(meth)acrylate, diethyleneglycol di(meth) acrylate, triethyleneglycol di(meth)acrylate, tetraethyleneglycol di(meth)acrylate, neopentylglycol di(meth) acrylate, polyethyleneglycol di(meth)acrylate, a bifunctional compound such as hydroxypivalic ester neopentylglycol di(meth) acrylate, trimethylolpropane tri(meth)acrylate, a tri or higher functional compound such as pentaerythritol tri(meth)acrylate.

Examples of the multifunctional (meth)acrylate oligomer ② include polypentaerythritol poly(meth)-acrylate, ε-caprolactone modified dipentaerythritol hexa(meth)acrylate, polyester (meth) acrylate, polyurethane (meth)acrylate, epoxy (meth)acrylate, polyether (meth)acrylate, melamine (meth)acrylate, oligo(meth) acrylate, alkyd (meth)acrylate, polyol (meth)acrylate and a prepolymer having at least 2 (meth)acryloyl groups such as silicon (meth)acrylate. The important prepolymer among them is the polypentaerythritol poly(meth)acrylate, the ε-caprolactone modified dipentaerythritol hexa(meth)acrylate, the polyester (meth)-acrylate, the epoxy (meth)acrylate and the polyurethane (meth)acrylate.

The polypentaerythritol poly(meth)acrylate is specifically represented by the general formula (X):

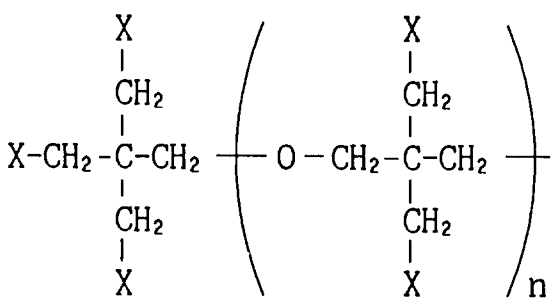

· · · (X)

wherein n represents an integer of 1 to 4 and at least 3 substituents of all Xs each are represented by the general formula (XI):

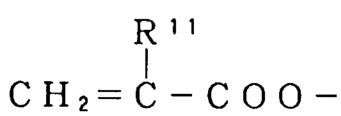

· · · (XI)

wherein $R^{11}$ represents a hydrogen atom or a methyl group, and the rest of Xs each represent an OH group.

Furthermore, the ε-caprolactone modified dipentaerythritol hexa(meth) acrylate is specifically represented by the general formula (XII):

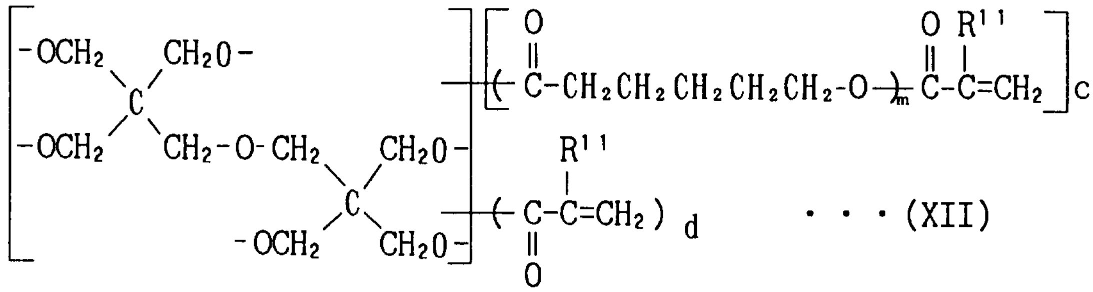

• • • (XII)

wherein $R^{11}$ has the same meaning as defined above, m represents 1, c represents an integer of 1 to 6 and d represents 0 or an integer of 1 to 6, both integers satisfying $c + d = 6$.

Furthermore, the polyester (meth)acrylate is obtained, for example according to the following method: at first, a polyester is obtained from a polyhydric alcohol such as ethyleneglycol, 1,4-butanediol, 1,6-hexanediol, diethyleneglycol, trimethylolpropane, dipropyleneglycol, polyethyleneglycol, polypropyleneglycol, pentaerythritol and dipentaerythritol and a polybasic acid such as phthalic acid, adipic acid,

maleic acid, trimellitic acid, itaconic acid, succinic acid, terephthalic acid and alkenylsuccinic acid. Then, the polyester is combined with a (meth)acrylate to form the desired polyester (meth)acrylate.

Specific examples thereof include the polyester (meth) acrylates each comprising an adipic acid/1,6-hexanediol/(meth) acrylic acid system, a phthalate anhydride/propyleneoxide/(meth) acrylic acid system, a trimellitic acid/diethyleneglycol/acrylic acid system and the like.

The epoxy (meth)acrylate is obtained by esterifying, for example an epoxy group of an epoxy resin with a (meth)acrylic acid to make a (meth)acryloyl group from the functional group.

Specific examples thereof include the epoxy (meth)acrylates each combining a bisphenol A-epichlorohydrin type epoxy resin with a (meth)acrylic acid, a phenolnovolac-epichlorohydrin type epoxy resin with a (meth)acrylic acid, a cycloaliphatic type epoxy resin with a (meth)acrylic acid and the like.

Moreover, the polyurethane (meth )acrylate can be obtained by reacting an isocyanate compound such as tolylene diisocyanate with a (meth) acrylate having a hydroxyl group such as 2-hydroxyethyl (meth)-acrylate. In the molecule of many polyurethane (meth)acrylates, a polyester structure is situated in the center and the isocyanate groups at both ends, combined with the (meth) acrylate.

Furthermore, the multifunctional urethane (meth)acrylate ③ can be obtained by reacting a (meth)-acrylate containing a hydroxy group with a polyisocyanate.

Examples of the (meth)acrylate containing the hydroxy group include pentaerythritol triacrylate, pentaerythritol tetraacrylate, dipentaerythritol pentaacrylate, dipentaerythritol hexaacrylate, trimethylolpropane diacrylate, their two or more mixture and a mixture of two or more selected from these compounds and 2-hydroxyethyl acrylate, 2-hydroxyethyl methacrylate, hydroxypropyl acrylate, hydroxypropyl methacrylate, hydroxyhexyl acrylate, hydroxyhexyl methacrylate and the like. The "A-TMM•3L" mixing a pentaerythritol triacrylate and a pentaerythritol tetraacrylate (supplied by Shin Nakamura Chemical Industries Co., Ltd.), "DPHA" mixing a dipentaerythritol pentaacrylate and a hexaacrylate (supplied by Nihon Kayaku Co., Ltd.) and the like have been on market and can be used in the present invention as a mixture of 2 or more compounds.

As the polyisocyanate, all those of the aliphatic, aromatic or cycloaliphatic origin can be used in the present invention. Their examples include methylene diisocyanate, tetramethylene diisocyanate, hexamethylene diisocyanate, 2,2,4-trimethylhexamethylene diisocyanate, isophorone diisocyanate, xylene diisocyanate, dicyclohexylmethane diisocyanate, tolylene diisocyanate, phenylene diisocyanate, methylenebisphenyl diisocyanate and the like. Their two or more mixture is acceptable as well. Preferred is a polyisocyanate capable of providing a non-yellowing polyurethane.

The crosslinkable compound as the component (C) has a cure shrinkage of 6% or less, preferably 4.5% or less.

The crosslinkable compound having the cure shrinkage of 6% or less occurs in various forms. Their examples include ① a (meth)acrylate modified polymer resulting from the modification by means of epoxy, urethane, alkydurethane, polycaprolactone, unsaturated acid modified drying oil, polyester, polyether and the like, ② a curable (meth)acrylate monomer and ③ a halogenated polyester and the like.

First of all, the (meth)acrylate modified polymer ① contains an ultraviolet ray-reactive acrylate group in its polymer. Ordinarily, the (meth)acrylate modified polymer is represented by the general formula (XIII):

Polymer[Acrylate]$_e$ (XIII)

wherein e represents an integer of 1 to 5, Polymer represents a polymer having an valence of e and Acrylate represents a (meth) acrylic ester.

A bifunctional polymer wherein e is 2 has a structure as follows:

Acrylate-Polymer-Acrylate

And, a trifunctional polymer wherein e is 3 has a structure as follows:

$$\text{Acrylate-}\underset{\underset{\text{Acrylate}}{|}}{\text{Polymer}}\text{-Acrylate}$$

Accordingly, a polymer which comprises bonding monofunctional acrylates is represented by the general formula (XIV):

$$\text{Polymer}\left[-O-\overset{\overset{O}{\|}}{C}-CH=CH_2\right]_e \quad \cdots \text{(XIV)}$$

wherein Polymer and e have the same meaning as defined above. Moreover, a polymer which comprises bonding multifunctional acrylates is represented by the general formula (XV):

$$\text{Polymer}\left(R^{12}\left[O-\overset{\overset{O}{\|}}{C}-CH=CH_2\right]_h\right)_e \quad \cdots \text{(XV)}$$

wherein Polymer and e have the same meaning as defined above, $R^{12}$ represents a bivalent hydrocarbon group and h is 1 to 6.

And, a polymer which comprises bonding both monofunctional and multifunctional acrylates is represented by the general formula (XVI):

$$\left[H_2C=CH-\overset{\overset{O}{\|}}{C}-O\right]_g\text{Polymer}\left(R^{12}\left[O-\overset{\overset{O}{\|}}{C}-CH=CH_2\right]_h\right)_f \quad \cdots \text{(XVI)}$$

wherein Polymer, h and $R^{12}$ have the same meaning as defined above, f and g each represent an integer of 1 to 3 and the total of f and g is 5 or less.

Representative examples of such a (meth)acrylate modified polymer include an acrylate polyester represented by the general formula (XVII):

$$CH_2=CH-\overset{\overset{O}{\|}}{C}-O(CH_2)_6\left[-O\overset{\overset{O}{\|}}{C}-(CH_2)_4-\overset{\overset{O}{\|}}{C}-O-(CH_2)_6-\right]_i O-\overset{\overset{O}{\|}}{C}-CH=CH_2 \quad \cdots \text{(XVII)}$$

wherein i is 1 to 20; an acrylate epoxy represented by the general formula (XVIII):

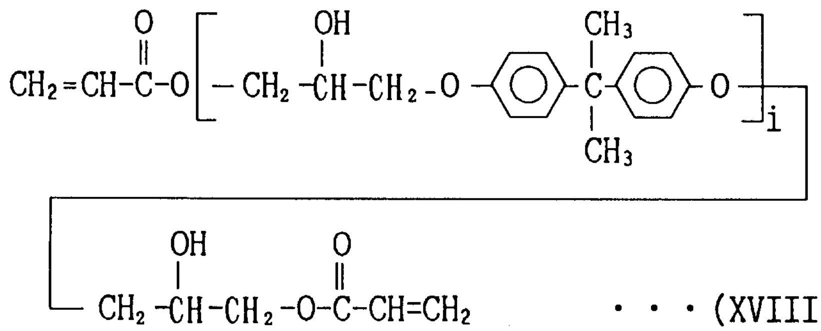

... (XVIII)

wherein i is 1 to 20; and an acrylate urethane and the like represented by the general formula (XIX):

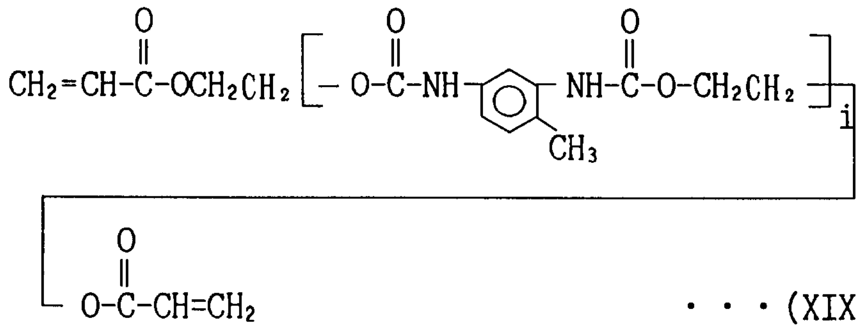

... (XIX)

wherein i is 1 to 20.

Other than these, examples of the (meth)acrylate modified polymer also include (meth)acrylate alkydurethane, (meth) acrylate polycaprolactone, (meth)acrylate unsaturated acid modified drying oil and the like.

Next, the curable (meth)acrylate monomer ② can take various forms, and their specific examples include:

(a) Spiro acetal-based compounds
(b) (iso)cyanurate-based compounds
(c) melamine-based compounds
(d) compounds having a cycloaliphatic skeleton

and the like.

Examples of the Spiro acetal-based compound (a) include a (meth) acrylate compound having a spiro acetal skeleton within its molecule as represented by either or both of the general formula (XX):

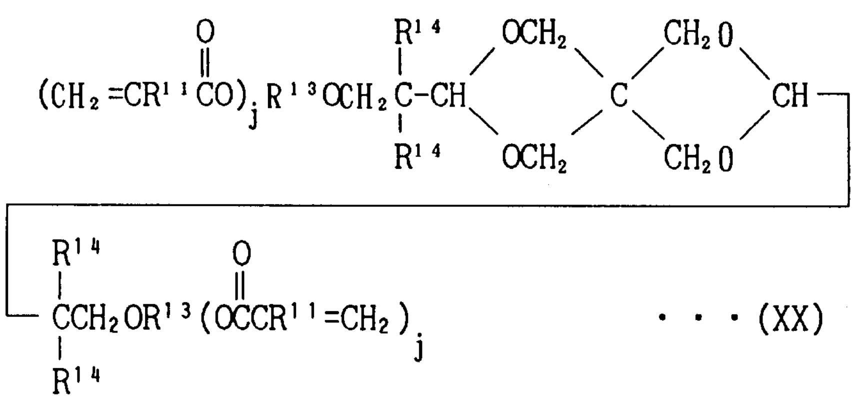

... (XX)

wherein $R^{11}$ has the same meaning as defined above, $R^{13}$ represents $-C(R^{15})_{3-j}\cdot R^{16}$ (provided, however, that $R^{15}$ represents a hydrogen atom or an alkyl group having 4 or less carbon atoms and $R^{16}$ represents a straight chain or branched chain alkylene group having 7 or less carbon atoms or an oxyalkylene group or hydroxyalkylene group containing an ethereal oxygen atom), $R^{14}$ represents a hydrogen atom or a methyl

group and j represents an integer of 1 to 3; and the general formula (XXI):

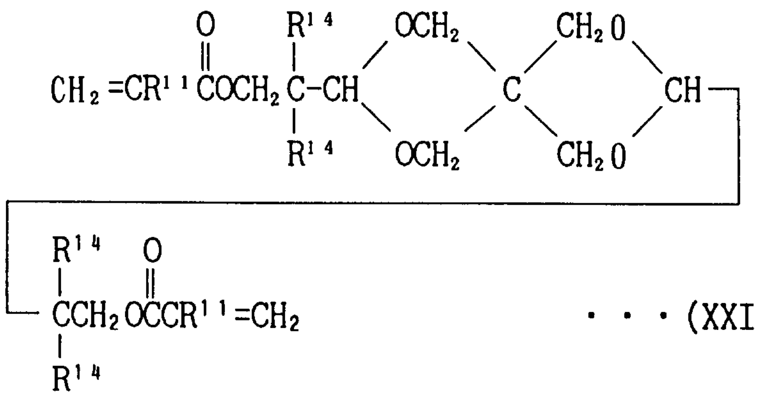

· · · (XXI)

wherein $R^{11}$ and $R^{14}$ have the same meaning as defined above.

The (iso)cyanurate-based compound (b) is an (iso)cyanurate compound having an (iso) cyanurate skeleton within its molecule. Examples thereof include a (meth)acryloyloxyalkyl (iso)cyanurate and the like represented by the general formula (XXII):

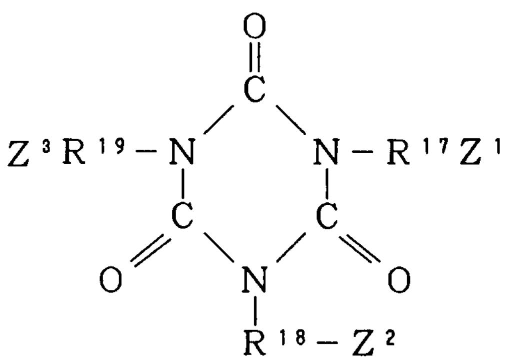

· · · (XXII)

wherein $R^{17}$, $R^{18}$ and $R^{19}$ each represent a (poly)oxyalkylene group, $Z^1$, $Z^2$ and $Z^3$ each represent a hydrogen atom or an alkyl group or (meth) acryloyl group having 1 to 10 carbon atoms; or the general formula (XXIII):

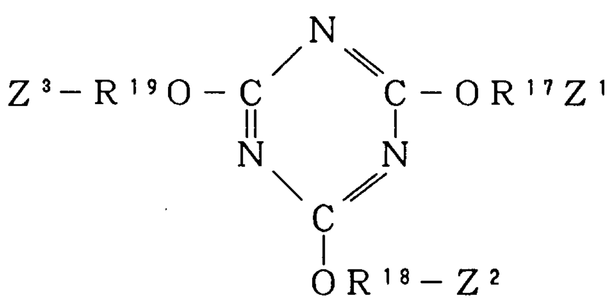

· · · (XXIII)

wherein $R^{17}$, $R^{18}$, $R^{19}$, $z^1$, $z^2$ and $Z^3$ have the same meaning as defined above.

The melamine-based compound (c) is a melamine compound having a melamine skeleton within its molecule, for example a (meth)acrylate compound containing a melamine group represented by the general formula (XXIV):

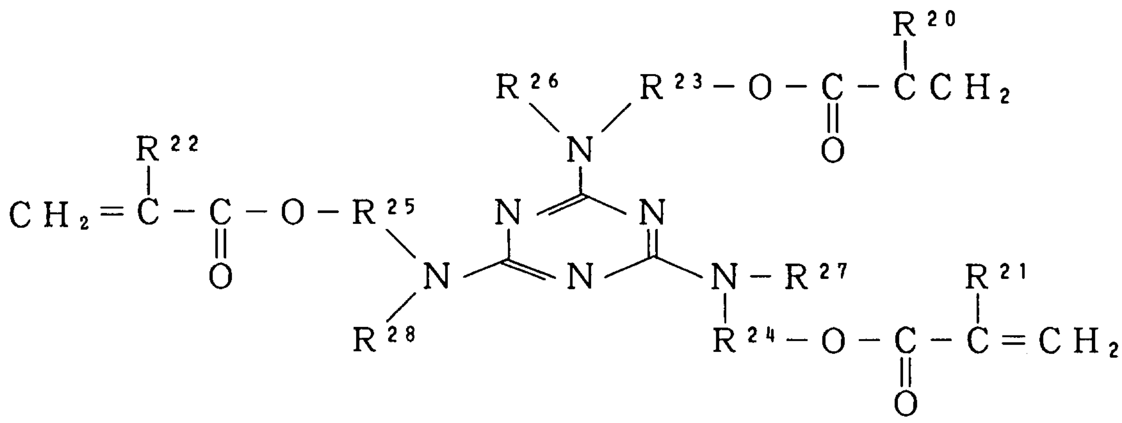

· · · (XXIV)

wherein $R^{20}$, $R^{21}$ and $R^{22}$ each independently represent a hydrogen atom or a methyl group, $R^{23}$, $R^{24}$ and $R^{25}$ each independently represent an alkylene group having 2 to 10 carbon atoms and $R^{26}$, $R^{27}$ and $R^{28}$ each independently represent a hydrogen atom or a hydrocarbon group having 1 to 10 carbon atoms; or the general formula (XXV):

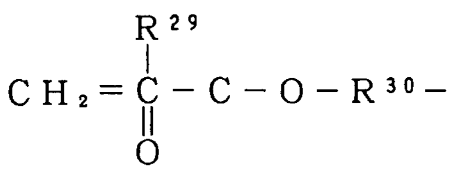

· · · (XXV)

wherein $R^{29}$ represents a hydrogen atom or a methyl group and $R^{30}$ represents an alkylene group having 2 to 10 carbon atoms.

The compound having a cycloaliphatic skeleton (d) is, for example a (meth)acrylic ester compound having a tricyclodecane group represented by the general formula (XXVI):

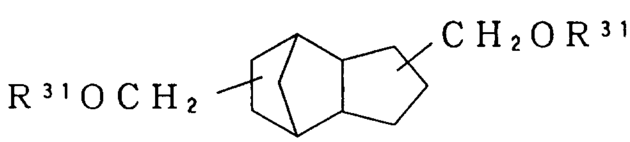

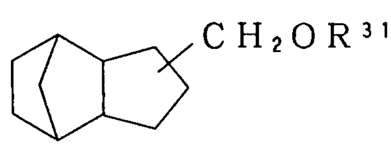

· · · (XXVI)

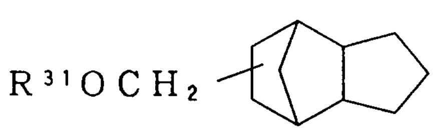

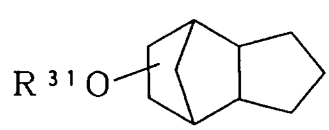

wherein $R^{31}$ represents $COCHC=CH_2$ or $COC(CH_3)C=CH_2$; or a bifunctional compound represented by the general formula (XXVII)

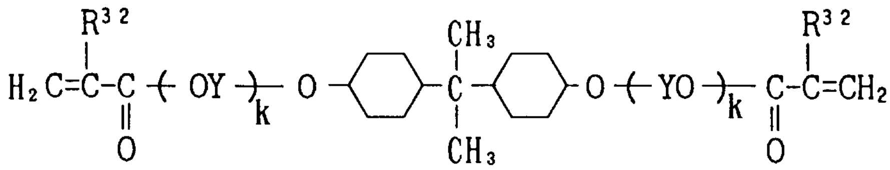 • • (XXVII)

wherein $R^{32}$ represents a hydrogen atom or a methyl group, k represents 0 or an integer of 1 to 5, Y represents an alkylene group having 6 or less carbon atoms or a group obtained by substituting a hydrogen atom of said alkylene group with a hydroxyl group and these Ys may be same or different when k is 2 or more.

Furthermore, the halogenated polyester ③ is a product obtained by halognating a polyester polymer with a halogen element (fluorine, chlorine, bromine and the like).

The EBECRYL 584, 585, 586 and 588 (supplied by Daicel•UCB Co., Ltd.) on market can be used as the halogenated polyester of the present invention.

The curable resin composition of the present invention is made of above-mentioned components (A), (B) and (C). The components (A) and (B) are mixed at a ratio by weight of 5 to 90%, preferably 40 to 80% of (A) to 95 to 10%, preferably 60 to 20% of (B). The component (C) is mixed at a ratio by weight of 5 to 70%, preferably 10 to 50% to the amount of totaling (A) and (B) at above-mentioned ratio and other components aimed at responding to various uses may be added as they are required.

Meanwhile, the cured resin film has undesirably a low mechanical strength at the mixing ratio by weight of less than 5% and a low rate of cure at that of more than 90% of the component (A). The cured resin film undesirably has poor weathering resistance and is intractable to coat in a great thickness at a mixing ratio by weight of less than 5% and has low surface hardness at that of more than 70% of the component (C).

To the curable resin composition of the present invention comprising the components (A), (B) and (C) as described above, various additives and assistants can be incorporated if necessary unless they should disturb the objects of the present invention.

For example, following additives can be used herein:

(a) Stabilizing agents: Quinone-based compounds such as hydroquinone.

(b) Fillers: Inorganic substances (talc, calcium carbonate, ceramics power, colloidal silica powder and the like)

and organic substances such as pigment and dye (provided, however, that any substances likely to cause the loss of transparency should not be used.)

(c) Additives for weathering resistance: UV absorbents, light stabilizers, aging preventives and the like.

(d) Other additives: antistatic agents, defogging agents, lubricants and the like. (provided, however, that any substances likely to cause the loss of transparency should not be used.)

Furthermore, in a curing process wherein an ultraviolet ray or a visible ray is used as a cure promoter, it is preferable to add a photopolymerization initiator such as 1-hydroxycyclohexyl phenylketone, dibenzoyl, benzoylmethylether, benzoylethylether, p-chlorobenzophenone, p-methoxybenzophenone, benzoylperoxide, di-tert-butylperoxide, camphorquinone and the like. These photopolymerization initiators can be used singly or in their two or more mixture. Ordinarily, they are used in an amount selected from a range of 0.05 to 10.0 parts by weight to 100 parts by weight of the curable resin composition.

In a process for hot cure or cold cure, it is preferable to use a peroxide-based compound or an amine-based compound singly or in combination as a polymerization initiator. Examples of the peroxide-based compound include benzoylperoxide, p-chlorobenzoylperoxide, 2,4-dichlorobenzoylperoxide, t-butylhydroperoxide, di-tert-butylperoxide, dicumylperoxide, tert-butylperoxy acetate, diacetate, tert-butylperoxybenzoate and the the like.

Examples of the amine-based compound include N,N-diethanol-p-toluidine, dimethyl-p-toluidine, p-toluidine, methylamine, tert-butylamine, methylethylamine, diphenylamine, 4,4'-dinitrodiphenylamine, o-nitroaniline, p-bromoaniline, 2,4,6-tribromoaniline and the like. Ordinarily, the peroxide-based compound and amine-based compound are used in a total amount selected from a range of 0.05 to 5.0 parts by weight to 100 parts by weight of the curable resin composition.

Ordinarily, the curable resin composition of the present invention is coated on an appropriate base material and cured to provide a cured resin surface.

The base material is not particularly limited as regards what it is made from. Specific examples of its materials include a polyester, a polystyrene, an acrylic resin, a polycarbonate, a polyurethane, a polyethylene, a polypropylene, a polyamide resin, a vinyl chloride resin, a vinylidene chloride resin, a polyalkylene

terephthalate, a polyarylate, a polyarylene sulfide and the like or a resin composition containing these resin substances as the essential component or a composite material combining them with a reinforcer.

Preferred among them is a thermoplastic resin having comparatively high heat resistance, including polyester, polycarbonate, polyamide and the like.

Shapes of the base material are not particularly limited and it is agreeable that the base material is in the form of a single-layered or multilayered film or sheet or a molded product in various shapes.

The curable resin composition of the present invention is coated on the base material according to a known method for coating by means of, for example spinner, spray, roll coater, dipping and the like.

A diluent may be used to improve efficiency of coating the curable resin composition of the present invention on the base material.

Specific examples of the diluent include the ketones such as methylethylketone, methylisobutylketone and cyclohexane, the aromatic hydrocarbons such as benzene, toluene and xylene, the halogenated hydrocarbons such as chloroform and methylene chloride, the alcohols such as methanol, ethanol, propanol and butanol, the organic solvents including ethers such as tetrahydrofuran and dioxane, the ethylcellosolves, the butylcellosolves and the like. They are used singly or in their two or more mixture.

Preferred among them are the ketones, the alcohols or their mixed solvent. Particularly a mixed solvent containing methylisobutylketone or isopropyl alcohol or butyl alcohol is preferably used.

When the diluent is used, the mixing ratio between the diluent and the curable resin composition of the present invention is not particularly limited. Ordinarily, however, the diluent and the curable resin composition are mixed at a ratio by weight selected from a range of 1:9 to 9:1. Particularly, the mixture at a ratio of 9:1 to 5:5 is very suitable from the view point of working efficiency.

The curable resin composition of the present invention can be subjected to cold cure or hot cure or be cured by the irradiation of an activation energy ray (electron beam, ultraviolet ray, X ray, $\gamma$ ray or visible light or the like) and all of them are preferably used.

Of them, it is particularly preferable to irradiate the ultraviolet ray, and the ultraviolet ray having the wavelength in a range of 200 to 550nm is preferably irradiated for 0.1 second or more, preferably 0.5 to 10 seconds. The quantity of irradiated ray is ordinarily 30 to 5,000mJ/cm$^2$.

The cured resin film obtained by curing the curable resin composition of the present invention is excellent in the properties such as rate of cure, surface hardness and transparency, keeping these properties well-balanced and markedly improving the surface profile of the base material.

This cured resin film can be obtained by coating the curable resin composition of the present invention and only one coat thereof, and it is not always necessary that the base material should receive the surface treatment or be undercoated with a primer. However, base materials of certain kind are preferably provided with the surface or primer treatment to improve the adhesiveness of the cured resin film.

It is preferable that the cured resin film obtained by coating the curable resin composition of the present invention should have a thickness in a range of 0.01 to 1,000 $\mu$m. A cured resin film having a thickness of less than 0.01 $\mu$ often is short of mechanical strength such as surface hardness. With a film having a thickness of more than 1000 $\mu$m, the flexibility inherent in the base material is deteriorated.

As described above, the curable resin composition of the present invention is capable of providing a cured resin film excellent in surface hardness, transparency, cigarette resistance and having good resistance to disfigurement.

Accordingly, the curable resin composition of the present invention can be effectively used for coating of automobiles, building materials, woodworking products, floor cover materials and the like.

Next, the present invention will be described in greater detail below with reference to Preparation Examples and Examples. However, these Preparation Examples and Examples are non-limitative relative to the present invention.

Preparation Example

Preparation of the curable phosphazene compound

55.0g (0. 167mol) of hexachlorocyclotriphosphazene [a cyclic compound represented by the formula $(NPCl_2)_3$, hereinafter referred to as "3PNC"] , 50ml of toluene and 158g (2.0mol) of pyridine were placed and stirred in a 1 liter flask equipped with a thermometer, a stirrer, a dropping funnel and a condenser.

To them was slowly added dropwise 143g (1.1mol) of 2-hydroxyethyl methacrylate (hereinafter referred to as "HEMA") from the dropping funnel.

The mixture was placed on a hot bath, heated to 80 °C and caused to react with stirring for 8 hours.

Then, the precipitated crystals and the solvent in the filtrate were removed by distilling them under reduced pressure. The filtrate was dried well to obtain 136g of 1,1,3,3,5,5-hexa(methacryloylethylenedioxy)-cyclotriphosphazene (the curable phosphazene compound) occurring as a yellow liquid. The yield was found to be 91%.

Examples and Comparative Examples

A certain number of coating agents were prepared by mixing the curable phosphazene compound obtained in the Preparation Example with the solvents at the ratios as shown in Table 1.

The so obtained coating agents were tested to determine their shrinkage factor.

The shrinkage factor was calculated according to the following formula, with the use of the density $C_A$ of resin components in each coating agent before it is cured (the values obtained by measurement with a Harvard specific gravity bottle) and the density $C_B$ of a cured substance which was obtained by irradiating the ultraviolet ray to a composition wherein benzophenone was added to the same above resin components at a ratio by weight of 5% (the values obtained by measurement according to the specific gravity method).

Shrinkage factor = $[1-(C_B/C_A)] \times 100$

The results of the shrinkage factor determination are given in Table 1.

Meanwhile, the notes in Table 1 have the meaning that follows:

*1: PPZ, supplied by Idemitsu Petrochemical Co., Ltd.

*2: Urethane acrylate UA-306H (pentaerythritol triacrylate hexamethylene diisocyanateurethane prepolymer), supplied by Kyoeisha Chemical Co., Ltd.

*3: EBECRYL 584, supplied Daicel•UCB Co.. Ltd.

*4: SARTOMER 9505, supplied by SARTOMER Company

*5: Purchased from market.

Table 1

| | | | Example 1 | Example 2 | Comparative Example 1 | Comparative Example 2 | Comparative Example 3 |
|---|---|---|---|---|---|---|---|
| Curable phosphazene compound *1 | | | 20 | 20 | 20 | – | 20 |
| Multifunctional acrylate compounds | Dipentaerythritol hexaacrylate | | 20 | – | 20 | – | 20 |
| | Hexafunctional urethane acrylate *2 | | – | 20 | – | – | – |
| Crosslinkable compounds | Shrinkage factor of 6 % or less | Diluted hexamethylenediol diacrylate of chlorinated polyester *3 | 10 | – | – | – | – |
| | | Bifunctional urethane acrylate *4 | – | 10 | – | – | – |
| | Trimethylolpropane triacrylate having shrinkage factor of 6 % or more | | – | – | – | – | 10 |
| Solvents | Isopropyl alcohol | | 20 | 20 | 20 | – | 20 |
| | Methylisobutylketone | | 30 | 30 | 30 | – | 30 |
| | Butanol | | 20 | 20 | 20 | – | 20 |
| Polymerization initiator | 1-Hydroxy-cyclohexyl-phenylketone | | 1 | 1 | 1 | – | 1 |
| Acrylic coating agent *5 | | | – | – | – | 500 | – |
| Shrinkage factor | | | 5.8 | 5.7 | 6.5 | 5.0 | 6.3 |

Next, each coating agent was coated on a sheet made of polycarbonate having a thickness of 3mm according to the spray coating method. After it was dried, the coated sheet was cured by irradiating 250mJ/$cm^2$ of an ultraviolet ray to obtain a 30$\mu$ m thick cured resin film.

The performance of the cured resin films obtained in the Examples and Reference Examples was evaluated by determining each aspect of surface profile, surface hardness, pencil hardness and the like.

The results of the performance evaluation test are given in Table 2.

Each aspect of the performance was evaluated by using the following devices and test methods:

① The surface profile of the cured resin films

Peels, cracks, blisters and the like were macroscopically observed.

② Surface hardness

Determined by using a Taber's abrasion resistance testing machine. CS-10: 500g, 100 times

③ Pencil hardness test

4H: The film remained undamaged with a scratch of a 4H pencil but was found to have a mark with that of a 5H pencil.

3H: The film remained undamaged with a scratch of a 3H pencil but was found to have a mark with that of a 4H pencil.

2B: The film remained undamaged with a scratch of a 2B pencil but was found to have a mark with that of a B pencil.

④ Light transmittance

According to JIS K-7105

⑤ Cigarette resistance

A cigarette was subjected to the spontaneous combustion on a cured resin film. Then, the tar was wiped off the surface with the use of isopropyl alcohol and the scorch on the cured resin film and the substrate was evaluated by macroscopically determining its degree.

Criterion

○: No changes at all.

Δ: Mildly "scorched" mark.

X: Markedly "scorched" mark.

⑥ Weathering resistance

According to Paragraph 4.16 (Weathering resistance test method) of JIS D 0202 (General rules, Film of automobile parts).

Test method

By using a sunshine carbon arc lamp type weather meter under the conditions of a temperature of 63±3°C at the black panel and spraying every 12 minutes during the irradiation for 60 minutes. After the elapse of 1,000 hours, the surface profile of the cured resin films (blisters, peels, cracks, stains, marks and the like) was evaluated macroscopically.

Table 2

| | | Example | | Comparative Example | | |
|---|---|---|---|---|---|---|
| | | 1 | 2 | 1 | 2 | 3 |
| Surface profile of films | | Good | Good | Peeled & cracked | Good | Peeled & cracked |
| Surface hardness | | 12 | 13 | Could not be determined | 36 | Could not be determined |
| Pencil hardness | | 4H | 4H | | 2B | |
| Light transmittance (%) | | 90.9 | 91.3 | | 90.1 | |
| Cigarette resistance | Substrate | ○ | ○ | | × | |
| | Film | ○ | ○ | | × | |
| Weathering resistance | | In good order | In good order | Film peeled | In good order | Film peeled |

## Claims

1. A curable resin composition comprising (A) a curable phosphazene compound, (B) a multifunctional (meth)acrylate-based compound and (C) a crosslinkable compound having a cure shrinkage of 6% or

less.

2. The curable resin composition according to Claim 1, comprising 5 to 90% by weight of the curable phosphazene compound (A), 95 to 10% by weight of the multifunctional acrylate-based compound (B) and the crosslinkable compound having the cure shrinkage of 6% or less (C) at a ratio by weight of 5 to 70% to the amount of totaling the components (A) and (B).

3. The curable resin composition according to Claim 1, wherein the curable phosphazene compound (A) is a phosphazene compound having a repeating unit represented by the general formula (I):

$$\text{-}\!\!\left( NP(A)_a(B)_b \right)\!\!\text{-} \qquad (I)$$

wherein A represents a polymerizable and curable group, B represents a polymerizable and non-curing group and a and b represent real numbers mutually satisfying $0<a$, $0 \leqq b$ and $a+b=2$.

4. The curable resin composition according to Claim 1, wherein the curable phosphazene compound (A) is a cyclic or chain phosphazene compound represented by any one of the following formulae:

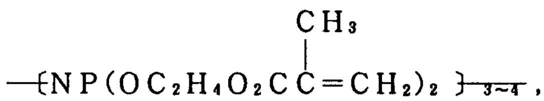

$-\!\!\{NP(OCH_2CH{=}CH_2)_2\}_{3\sim4}$ ,

$-\!\!\{NP(OC_2H_4O_2CCH{=}CH_2)_2\}_{3\sim4}$ ,

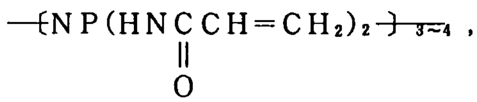

$-\!\!\{NP\ \{(OCH_2CH_3)(OC_2H_4O_2CCH{=}CH_2)\}\}_{3\sim4}$ ,

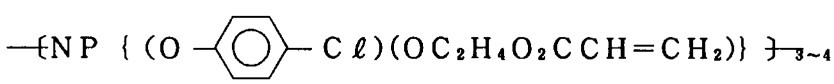

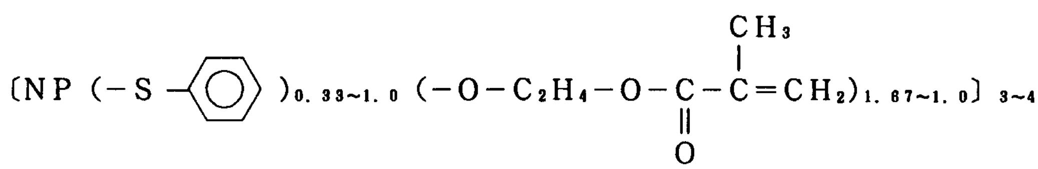

,

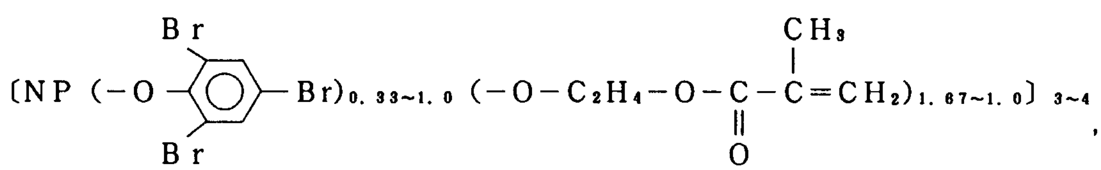

,

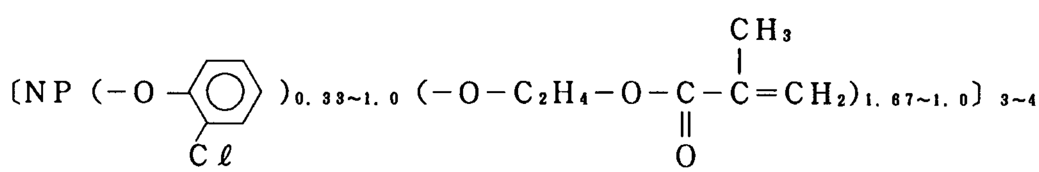

,

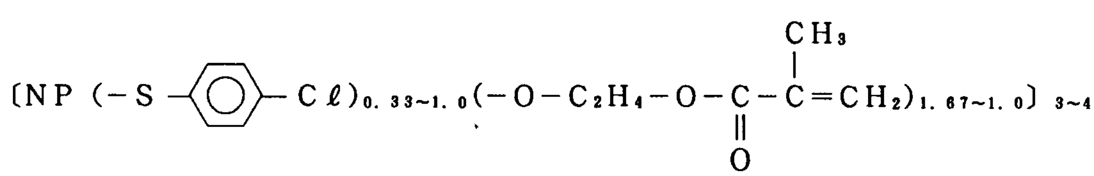

,

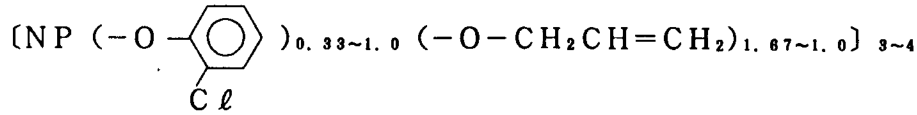

**5.** The curable resin composition according to Claim 1, wherein the multifunctional acrylate-based compound (B) is a multifunctional (meth)acrylate monomer, a multifunctional (meth)acrylate oligomer or a multifunctional urethane (meth) acrylate.

6. The curable resin composition according to Claim 5, wherein the multifunctional (meth)acrylate monomer is a bifunctional compound selected from the group consisting of 1,3-butanediol di(meth)-acrylate, 1,4-butanediol di(meth)acrylate, 1,6-hexanediol di(meth)acrylate, ethyleneglycol di(meth)-acrylate, diethyleneglycol di(meth)acrylate, triethyleneglycol di(meth) acrylate, tetraethyleneglycol di-(meth)acrylate, neopentylglycol di(meth)acrylate, polyethyleneglycol di(meth)acrylate and hydroxypivalic ester neopentylglycol di(meth)acrylate.

7. The curable resin composition according to Claim 5, wherein the multifunctional (meth)acrylate monomer is a trimethylolpropane tri(meth)acrylate or a pentaerythritol tri(meth)acrylate.

8. The curable resin composition according to Claim 5, wherein the multifunctional (meth)acrylate oligomer is a polypentaerythritol poly(meth)acrylate, a$\epsilon$-caprolactone modified dipentaerythritol hexa-(meth)acrylate, a polyester (meth)acrylate, a polyurethane (meth)acrylate, an epoxy (meth) acrylate, a polyether (meth)acrylate, a melamine (meth) acrylate, an oligo(meth)acrylate, an alkyd (meth)acrylate, a polyol (meth)acrylate or a silicon (meth)acrylate.

9. The curable resin composition according to Claim 5, wherein the multifunctional urethane (meth)-acrylate is a product obtained by reacting a (meth)acrylate containing a hydroxy group with a polyisocyanate.

10. The curable resin composition according to Claim 1, comprising the crosslinkable compound (C) having a cure shrinkage of 4.5% or less.

11. The curable resin composition according to Claim 1, wherein the crosslinkable compound (C) is a (meth)acrylate modified polymer, a curable (meth)acrylate monomer or a halogenated polyester.

12. The curable resin composition according to Claim 11, wherein the (meth)acrylate modified polymer is a (meth)acrylate modified polyester, a (meth)acrylate modified epoxy, a (meth) acrylate modified urethane, a (meth)acrylate modified alkydurethane, a (meth)acrylate modified polycaprolactone or a (meth)acrylate unsaturated acid modified drying oil.

13. The curable resin composition according to Claim 11, wherein the curable (meth)acrylate monomer is a spiro acetal-based compound, an (iso)cyanurate-based compound, a melaminebased compound or a compound having a cycloaliphatic skeleton.

14. The curable resin composition according to Claim 11, wherein the halogenated polyester is a product obtained by halogenating a polyester polymer with a halogen element.